# EUROPÄISCHE PATENTANMELDUNG

(11) **EP 2 148 253 A1**
(43) Veröffentlichungstag der Anmeldung: **27.01.2010**
(21) Anmeldenummer: 08013131.1
(22) Anmeldetag: 22.07.2008
(51) Int. Cl.: G04G 17/04

(54) **Vorrichtung zur Zeitanzeige**

(71) Anmelder: D. Swarovski & Co., 6112 Wattens (AT)
(72) Erfinder: Kurtze, Andreas, 6122 Fritzens (AT); Lanthaler, Clemens, 6166 Fulpmes (AT)
(74) Vertreter: Gangl, Markus

(57) **Zusammenfassung**

Vorrichtung zur Zeitanzeige, insbesondere eine Armbanduhr (1), umfassend eine Mehrzahl von Schmucksteinen (3) und eine Mehrzahl von Beleuchtungselementen, über die die Schmucksteine (3) zur Realisierung einer Zeitanzeige selektiv beleuchtbar und/oder durchleuchtbar sind, sowie eine Steuerungseinrichtung (19) zur Ansteuerung der Beleuchtungselemente, wobei die Steuerungseinrichtung (19) eine Leiterplatte (8) umfasst, wobei die Leiterplatte (8) im montierten Zustand gekrümmt ist.

## Beschreibung

Die Erfindung betrifft eine Vorrichtung zur Zeitanzeige, insbesondere eine Armbanduhr, umfassend eine Mehrzahl von Schmucksteinen und eine Mehrzahl von Beleuchtungselementen, über die die Schmucksteine zur Realisierung einer Zeitanzeige selektiv beleuchtbar und/oder durchleuchtbar sind, sowie eine Steuerungseinrichtung zur Ansteuerung der Beleuchtungselemente, wobei die Steuerungseinrichtung eine Leiterplatte umfasst.

Bereits mit Beginn der Uhrenfabrikation wurde es üblich, die hergestellten Uhren möglichst formschön auszuführen, damit diese neben ihrer Fähigkeit zur Anzeige der Tageszeit auch als Schmuckgegenstand dienen. Aus diesem Grund wurden auch insbesondere analoge Armbanduhren mit Schmucksteinen versehen.

Mit der Einführung von kompakten elektronischen Bauteilen und kleinen Beleuchtungsquellen, beispielsweise in Form von Leuchtdioden (LED) wurde es möglich, Zeitanzeiger zu realisieren, bei denen - elektronisch gesteuert - die Beleuchtungsquellen zur Anzeige der Zeit dienen, indem sie an der vom Betrachter entfernten Seite von Schmucksteinen angeordnet sind und diese dann durchleuchten. Aufgrund der optischen Eigenschaften von Schmucksteinen, insbesondere von Edelsteinen, ergeben sich damit besonders formschöne und luxuriös anmutende Zeitanzeiger.

Die DE 10 2004 058 245 A1 und die WO 2006/136587 A2 offenbaren beide Armbanduhren, bei denen an der Oberfläche der Armbanduhr Schmucksteine in die Armbanduhr eingebaut sind, wobei unter manchen dieser Schmucksteine Leuchtdioden zur Realisierung einer Zeitanzeige angeordnet sind.

Aufgrund der Schmucksteine und der darunterliegenden Leuchtdioden wird entweder die Bauhöhe der in diesen Schriften geoffenbarten Uhren unhandlich groß oder es steht wenig Platz für elektronische Komponenten, wie eine Steuerungseinrichtung, einen Taktgeber, eine Batterie od. dgl. zur Verfügung. Ein weiterer Nachteil ist, dass im Fall einer gekrümmten Uhrenanzeige weiter außen liegende Leuchtdioden aufgrund fehlender Ansteuerbarkeit nicht realisierbar sind.

Aufgabe der Erfindung ist es, obige Nachteile zu vermeiden und eine Vorrichtung zur Zeitanzeige zur Verfügung zu stellen, wo trotz derartiger Schmucksteine mit darunter liegenden Beleuchtungselementen genügend Platz für elektronische Komponenten zur Verfügung ist, aber dennoch eine handliche Größe des Zeitanzeigers nicht überschritten wird und auch weiter außen liegende Beleuchtungselemente gut ansteuerbar sind.

Dies wird durch eine Vorrichtung zur Zeitanzeiger mit den Merkmalen des Anspruchs 1 erreicht.

In der erfindungsgemäßen Vorrichtung zur Zeitanzeige ist eine Steuereinrichtung vorgesehen, die die Beleuchtungselemente ansteuert, wobei die Beleuchtungselemente selektiv die Schmucksteine beleuchten und zusätzlich oder alternativ die Schmucksteine durchleuchten. Dabei kann mit Hilfe einer Mehrzahl derartiger beleuchteter und/oder durchleuchteter Schmucksteine eine Zeitanzeige realisiert werden, beispielsweise indem die jeweils aktiven Beleuchtungselemente die Uhrzeit in alphanumerischen Zeichen darstellen oder aber durch die aktiven Beleuchtungselemente ein analoger Stunden- und Minutenzeiger sowie gegebenenfalls Sekundenzeiger imitiert wird. Auch eine Kombination von beidem sowie zusätzlich eine Datumsanzeige und weitere an sich bei Uhren bekannte Merkmale sind möglich. Zur Stromversorgung der erfindungsgemäßen Vorrichtung zur Zeitanzeige wird ebenso auf bekannte Mittel wie beispielsweise Akkumulatoren oder Batterien zurückgegriffen. Dabei können diese Akkumulatoren wiederaufladbare Batterien, Kondensatoren, induktiv aufladbare Akkus od. dgl. sein.

Neben der erwähnten Steuerungseinrichtung und der Vorrichtung zur Stromversorgung sind in einer erfindungsgemäßen Vorrichtung zur Zeitanzeige weitere elektronische Komponenten, wie beispielsweise ein Taktgeber bzw. Signalgeber meist in Form eines Quarzkristalls, der unter Stromfluss schwingt und für die Taktung der Zeitanzeige vorgesehen ist, vorhanden. Zur mechanischen Befestigung und elektrischen Verbindung der elektronischen Bauteile ist eine Leiterplatte vorgesehen, die einen Träger aus isolierendem Material mit festhaftenden leitenden Verbindungen umfasst. Dabei ist es beispielsweise möglich, die Leiterbahnen durch Ätzen aus einer dünnen Schicht leitfähigen Materials auf dem isolierenden Träger herzustellen oder die Leitungsstrukturen aufzudrucken. Auch andere im Stand der Technik bekannte Verfahren zur Herstellung von Leiterplatten sind möglich.

Ist nun eine derartige Leiterplatte im montierten Zustand gekrümmt und nicht eben, so kann diese sich gut an den durch äußere Randbedingungen, wie beispielsweise durch ein Gehäuse der Vorrichtung zur Zeitanzeige, vorgegebenen Platz anpassen, sodass die Leiterplatte selbst möglichst wenig Raum in Anspruch nimmt und für die elektronischen Bauteile genügend Platz vorhanden ist. Dies gilt insbesondere für eine Armbanduhr, wo aufgrund einer derartigen im montierten Zustand gekrümmten Leiterplatte das Uhrengehäuse selbst auch gekrümmt sein kann und somit besser an die Hand des Benutzers anpassbar ist und mehr Platz für das Display vorhanden ist, das ebenfalls eine gekrümmte Oberfläche aufweisen kann. Bei einer ebenen Leiterplatte ist hingegen ein gekrümmtes Gehäuse bzw. Display der Armbanduhr nur dann möglich, wenn das Uhrengehäuse selbst unhandlich groß wird.

Weitere vorteilhafte Ausführungen der Erfindung sind in den abhängigen Ansprüchen definiert und werden im Folgenden näher ausgeführt.

In einer besonders bevorzugten Ausführungsform der Erfindung ist die Leiterplatte selbst flexibel. Dadurch wird es ermöglicht, die Bestückung der Leiterplatte mit elektronischen Bauteilen in ebenem Zustand durchzuführen und diese erst beim Einbau in die Uhr zu krümmen. Außerdem kann eine derartige flexible Leiterplatte sich sehr gut an ein Uhrengehäuse anpassen, welches selbst eine gewisse Flexibilität aufweist und daher bei Benutzung der Uhr gewisse Formveränderungen erfährt. Dadurch wird weiters erreicht, dass eine Armbanduhr, welche eine derartige flexible Leiterplatte aufweist, ein Display haben kann, welches über einen gekrümmten Bereich der Armbanduhr verläuft.

Es kann aber auch vorgesehen sein, dass eine derartige Leiterplatte in einem starren Gehäuse angeordnet ist, wobei das starre Gehäuse an seiner Oberseite und seiner Unterseite (mit der die Armbanduhr am Arm des Benutzers aufliegt) dennoch eine Krümmung aufweisen kann, die ein Anschmiegen der Uhr an den Arm des Benutzers erleichtert bzw. eine großes Display zur Verfügung stellen kann.

In einer bevorzugten Ausführungsform ist die Leiterplatte gefaltet bzw. weist einen gefalteten Bereich auf. Dadurch wird es ermöglicht, dass Steuerelemente, die die Beleuchtungselemente selektiv ansteuern, und die Beleuchtungselemente selbst auf der gleichen Seite der Leiterplatte montiert bzw. befestigt sind, im Zeitanzeiger selbst aber platzsparend untereinander platziert sind

In einer Ausführungsform der Erfindung sind die Beleuchtungselemente direkt an oder auf der Leiterplatte befestigt. Besonders vorteilhaft ist es, wenn diese Beleuchtungselemente auf die Leiterplatte aufgelötet sind. Aber auch andere Befestigungsverfahren, wie Kleben, Klemmen oder Schweißen sind denkbar.

Insbesondere für die Verwendung der erfindungsgemäßen Vorrichtung als Armbanduhr sind die wesentlichen Bauteile klein und kompakt auszuführen. Aus diesem Grund ist es besonders bevorzugt, für die Beleuchtungselemente Leuchtdioden vorzusehen. Derartige Leuchtdioden zeichnen sich durch ihren geringen Raumbedarf, ihre geringe Hitzeentwicklung, ihren geringen Energiebedarf sowie ihre lange Haltbarkeit aus. Zusätzlich sind Helligkeit und Farbe des abgestrahlten Lichtes leicht regel- und steuerbar.

Besonders für die Darstellung von alphanumerischen Zeichen durch die Beleuchtungselemente ist vorgesehen, dass eine Vielzahl an derartigen Beleuchtungselementen samt zugehörigen Schmucksteinen für eine erfindungsgemäße Vorrichtung zur Zeitanzeige verwendet wird. Aus diesem Grund ist es vorteilhaft, kostengünstig herstellbare Schmucksteine, die aber dennoch formschön sind, zu verwenden. Dafür besonders prädestiniert sind künstliche oder natürliche Glassteine, die besonders formschön wirken, wenn sie, vorzugsweise facettiert, geschliffene Oberflächen aufweisen. Es ist aber auch möglich, andere natürliche oder synthetische Halbedelsteine oder Edelstein zu verwenden, obgleich dies mit erheblich erhöhten Materialkosten verbunden ist. Die Form, Gestalt und Größe der Schmucksteine ist prinzipiell beliebig und hängt von der Art und Größe der Vorrichtung zur Zeitanzeige ab.

Insbesondere bei der Verwendung als Armbanduhr ist es für eine erfindungsgemäße Vorrichtung zur Zeitanzeige ungünstig, die Beleuchtungselemente in einer Ebene anzuordnen, da dadurch noch weniger Raum für die Beleuchtungselemente und Schmucksteine zur Verfügung steht. Aus diesem Grund ist in einer Ausführungsform der Erfindung vorgesehen, dass die Spitzen und/oder die Tafeln der Schmucksteine eine einhüllende Fläche definieren, die ebenfalls, vorzugsweise konvex, gekrümmt ist. Dadurch kann sich die Armbanduhr gut an den Arm des Benutzers anschmiegen. Es kann dabei auch vorgesehen sein, dass das Uhrengehäuse nicht ganz starr ist, sondern zumindest innerhalb gewisser Grenzen flexibel ausgeführt ist.

In einer besonders bevorzugten Ausführungsform der Erfindung ist vorgesehen, dass die Schmucksteine zumindest abschnittsweise in Reihen und Spalten angeordnet sind, wodurch sich eine formschöne, dem Betrachter zugewandte Außenseite der Vorrichtung zur Zeitanzeige ergibt. Je nach Anzahl an verwendeten Schmucksteinen und Beleuchtungselementen können diese eine alphanumerische Darstellung der Zeitanzeige besonders gut realisieren. Das gleiche gilt für die Imitation eines analogen Minutenzeigers bzw. Stundenzeigers oder Sekundenzeigers. Es kann natürlich auch vorgesehen sein, dass die Anzeige zwischen diesen zwei Repräsentationsarten wechselt oder umschaltbar ist. Dabei kann vorgesehen sein, dass eine Steuerungseinrichtung in der Vorrichtung zur Zeitanzeige implementiert ist, die einerseits die Beleuchtungselemente einzeln ansteuern und andererseits zwischen verschiedenen Darstellungsarten schalten kann, sowie gegebenenfalls Helligkeit und Farbe des abgestrahlten Lichtes steuern kann.

Die Erfindung betrifft weiters ein Verfahren zur Herstellung einer Vorrichtung zur Zeitanzeige, wobei die verwendete Leiterplatte flexibel ist und in einem ebenen Zustand mit den Beleuchtungselementen bestückt wird und erst zur oder während der Montage in der Vorrichtung gekrümmt und/oder gefaltet wird. Im Falle einer gefalteten Leiterplatte können Steuereinrichtungen und Beleuchtungselemente besonders vorteilhaft auf der selben Seite der Leiterplatte befestigt werden.

Weitere Einzelheiten und Vorteile der vorliegenden Erfindung werden anhand der Figurenbeschreibung unter Bezugnahme auf die Zeichnungen im Folgenden näher erläutert. Darin zeigt:
- Fig. 1a bis 1c: eine Draufsicht der Oberseite und der Unterseite sowie eine Seitenansicht einer Ausführungsform der erfindungsgemäßen Vorrichtung zur Zeitanzeige,
- Fig. 2a bis 2c: eine weitere Seitenansicht sowie zwei perspektivische Ansichten dieser Ausführungsform der erfindungsgemäßen Vorrichtung,
- Fig. 3: eine Schnittdarstellung dieser Ausführungsform der erfindungsgemäßen Vorrichtung,
- Fig. 4: eine weitere Schnittdarstellung der Ausführungsform der erfindungsgemäßen Vorrichtung,
- Fig. 5a und 5b: zwei verschiedene Ausführungsformen der Verbindung zwischen Schmucksteinen und Fassungen,
- Fig. 6: eine schematische Darstellung der Steuereinrichtung und der Anordnung der Beleuchtungselemente mit zugehörigen Steuerelementen und
- Fig. 7: eine schematische Darstellung der Realisierung einer Zeitanzeige mittels Beleuchtungselementen.

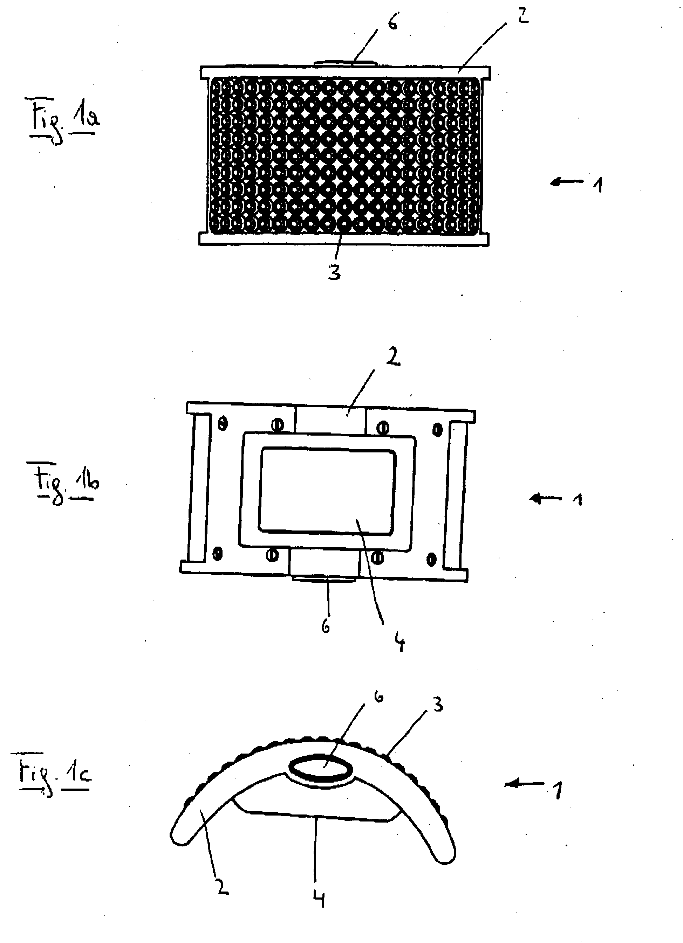

In den Fig. 1a bis 1c ist eine als Armbanduhr 1 ausgebildete Ausführungsform der erfindungsgemäßen Vorrichtung zur Zeitanzeige dargestellt, wobei aus Gründen der Übersichtlichkeit auf die Darstellung des Armbands selbst verzichtet wird. In Fig. 1a ist eine Draufsicht auf die Oberseite der Armbanduhr zu sehen. Dabei sind am Uhrengehäuse 2 eine Vielzahl von Schmucksteinen 3 in regelmäßigen Reihen und Spalten angeordnet. Unter mehreren dieser Schmucksteine 3 sind dabei Beleuchtungselemente in Form von Leuchtdioden 7 zur Realisierung einer Zeitanzeige angeordnet. Dabei ist vorgesehen, dass Licht von diesen Leuchtdioden 7 durch jene Schmucksteine 3 durchtritt, die über den Leuchtdioden 7 angeordnet sind. Dadurch kann beispielsweise mittels alphanumerischer Zeichen die Zeit dargestellt werden. Mittels eines Verstellknopfs 6 können verschiedene Einstellmöglichkeiten durchgeführt werden oder es kann die Darstellungsweise der Zeitanzeige gewechselt werden oder aber es kann durch Betätigen dieses Verstellknopfs 6 zumindest für ein gewisses Zeitintervall das Datum angezeigt werden. Fig. 1b zeigt eine Draufsicht der Untersicht der Armbanduhr 1. Dabei kann vorgesehen sein, dass der Boden 4 des Uhrengehäuses 2 zumindest bereichsweise transparent ist, womit Einblicke in die Elektronik der Armbanduhr 1 ermöglicht werden. Fig. 1c schließlich zeigt eine Seitenansicht der Armbanduhr 1, wo wiederum der Verstellknopf 6 und die über die Oberfläche des Uhrengehäuses 2 ragenden Schmucksteine 3 erkennbar sind.

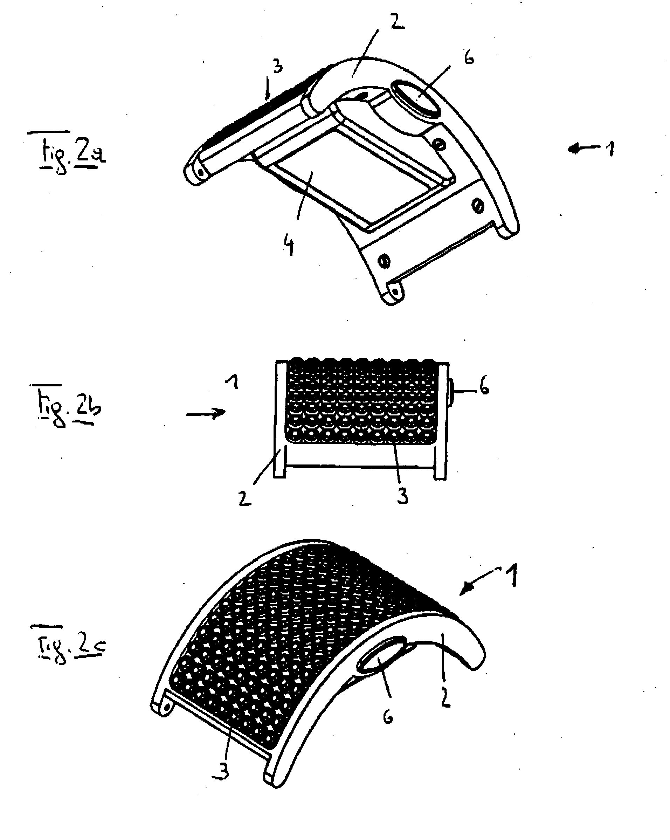

Fig. 2a und 2c zeigt eine perspektivische Ansicht einmal von oberhalb und einmal von unterhalb der erfindungsgemäßen Armbanduhr 1. Erkennbar ist, dass die in Reihen und Spalten angeordneten Schmucksteine 3 an ihrer Außenseite jeweils eine Tafel aufweisen, die insgesamt eine einhüllende Fläche definieren, welche eine konvexe Krümmung aufweist. Dadurch wird es ermöglicht, dass sich die Armbanduhr 1 an den Arm eines Trägers dieser Armbanduhr 1 anschmiegen kann. Es kann des Weiteren vorgesehen sein, dass das Uhrengehäuse 2 zumindest in gewissem Ausmaß flexibel ist. Aufgrund dieser erwähnten Krümmung ist es vorteilhaft, dass die Oberfläche des Trägers 16, an dem die Fassungen 5 der Schmucksteine 3 angeordnet sind selbst konvex gekrümmt ist. Aufgrund der Vielzahl an angeordneten Schmucksteinen 3 kann es auch ermöglicht werden, dass mehrere Merkmale gleichzeitig, beispielsweise Zeit-und Datumsanzeige, an der Armbanduhr 1 dargestellt werden.

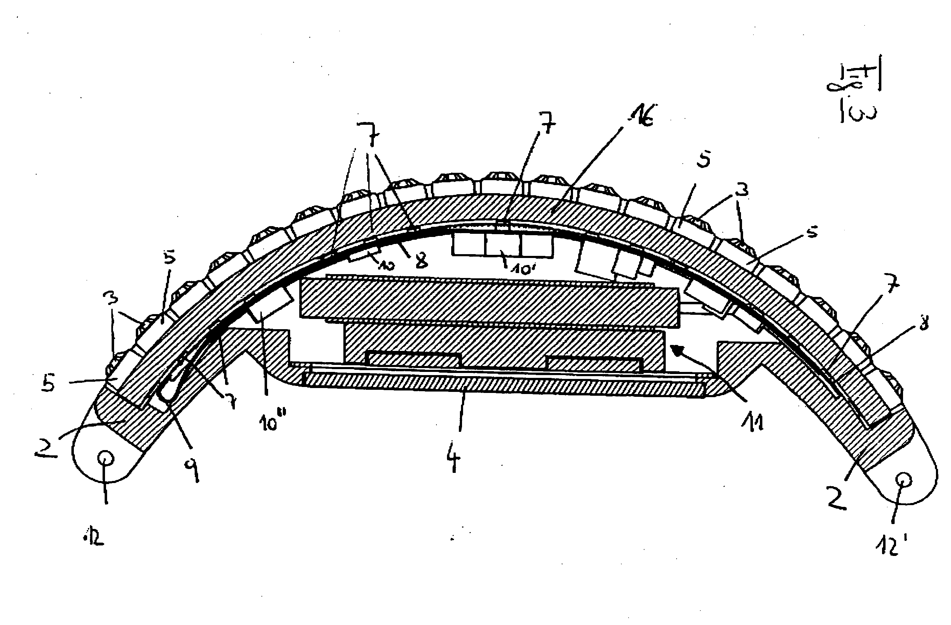

Fig. 3 zeigt eine Schnittdarstellung entlang der Umfangsrichtung der Armbanduhr 1 zwischen zwei Spalten von Schmucksteinen 3. Das Uhrengehäuse 2 selbst wird mittels zweier Vorrichtungen 12 und 12' am Armband befestigt. Über dem Uhrenboden 4 ist eine Steuereinheit 11 angeordnet, die neben der Steuerung der Leuchtdioden 7 auch zur Aufnahme der Mittel zur Stromversorgung, also beispielsweise eines Akkus oder einer oder mehrerer Batterien, dient. Auch ein für das Zeitsignal verantwortlicher Taktgeber, beispielsweise ein Quarzkristall kann hier untergebracht sein. Am Träger 16 sind eine Vielzahl von zylinderförmigen Fassungen 5 angeordnet, die über die Oberfläche des Trägers 16 hervorragen, also vom Träger 16 abstehen und an der dem Träger 16 entgegengesetzten Seite die Schmucksteine 3 halten. Dabei wird jeder Schmuckstein 3 von einer eigenen Fassung 5 gehalten. Zur Vereinfachung der Darstellung wird nicht jeder der in diesem Fall gleichartigen Schmucksteine 3 und Fassungen 5 mit einem Bezugszeichen versehen. Dasselbe gilt für die Leuchtdioden 7 und weitere Steuereinrichtungen 10.

An der Unterseite des Trägers sind unter manchen der Schmucksteine 3 Leuchtdioden 7 angeordnet, wobei das von ihnen ausgestrahlte Licht durch die über ihnen angeordneten Schmucksteine 3 durchtreten und dadurch eine Zeitanzeige realisieren kann. Weitere Steuereinrichtungen 10, 10',10" sind wiederum unter manchen der Leuchtdioden 7 angeordnet, wobei sich dazwischen die Leiterplatte 8 befindet. Diese dienen zur Steuerung der Zeitanzeige, indem die Leuchtdioden 7 selektiv angesteuert werden, sowie gegebenenfalls zur Steuerung der Helligkeit oder Farbe des von den Leuchtdioden 7 abgestrahlten Lichts.

Zur elektrischen Verbindung der Leuchtdioden 7 ist eine Leiterplatte 8 zwischen den Steuereinrichtungen 10, 10', 10" und den Leuchtdioden 7 angeordnet, wobei diese Leiterplatte 8 selbst ein Teil der gesamten Steuereinrichtung 19 der Armbanduhr 1 ist. Dabei sind die Leuchtdioden 7 direkt auf der Leiterplatte 8, beispielsweise durch Auflöten befestigt. Zur Anpassung an die konvexe Krümmung der Oberfläche des Trägers 16 ist diese Leiterplatte 8 selbst gekrümmt. In einem Bereich 9 der Leiterplatte 8 ist diese gefaltet, wodurch die elektrische Verbindung mit den Steuereinrichtungen 10, 10', 10^{a}, die ebenfalls direkt auf der Leiterplatte 8 angebracht sind, erleichtert wird. Durch eine derartige Krümmung bzw. Faltung der Leiterplatte 8 ist ein besonders platzsparender Einbau der nötigen elektrischen Verbindung der Leuchtdioden 7 möglich und auch ganz am Rand der Armbanduhr 1 gelegene Schmucksteine 3 können über derartige Leuchtdioden 7 durchleuchtet und/oder beleuchtet werden.

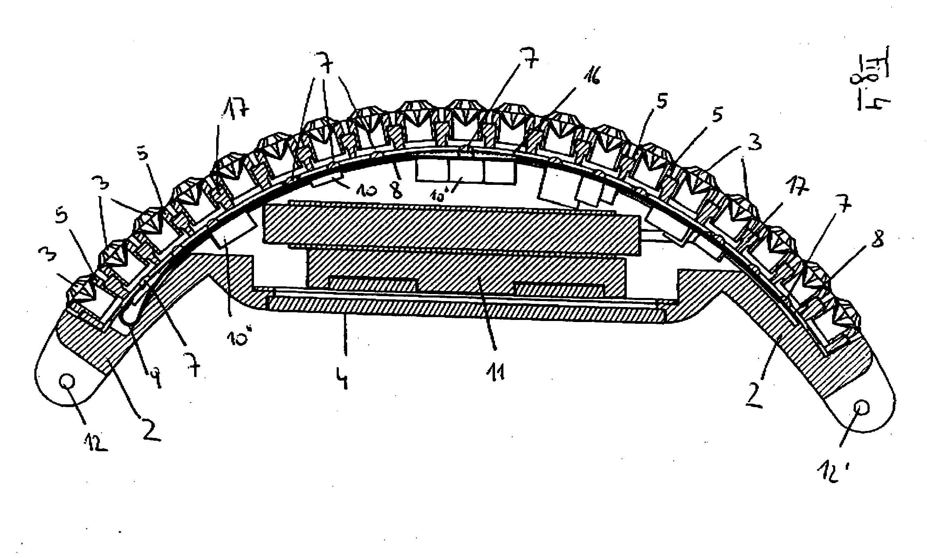

Fig. 4 zeigt eine weitere Schnittdarstellung der Armbanduhr 1, wobei die Schnittlinie parallel aber seitlich versetzt zu jener in Fig. 3 ist. In dieser Schnittdarstellung wird durch eine Spalte von Schmucksteinen 3 geschnitten, sodass das Innere der Fassungen 5 dargestellt wird. Zusätzlich zu jenen Merkmalen, die auch in Fig. 3 ersichtlich sind, kann man hier erkennen, dass die zylinderförmigen Fassungen 5 innen hohl, also hülsenförmig ausgebildet sind. Das von den unter manchen der Schmucksteine 3 angeordneten Leuchtdioden 7 emittierte Licht trifft direkt auf die Schmucksteine 3 und durchleuchtet dabei diese. Erkennbar ist des Weiteren, dass die Fassungen 5 durch Verbindungselemente 17 am Träger 16 gehalten werden. Dabei kann vorgesehen sein, dass die Fassungen 5 mittels der Verbindungselemente 17 an den Träger 16 geklemmt sind, oder aber andere übliche Metallverbindungsarten verwendet werden. Die innere Oberfläche der zylinderförmigen Fassungen 5 kann mit einer reflektierenden Schicht beschichtet sein, sodass ein besonders hoher Anteil des von den Leuchtdioden 7 emittierten Lichts durch den jeweiligen Schmuckstein 3 tritt. Zu sehen ist außerdem, dass die Längsachse 18 der zylinderförmigen Fassungen 5 jeweils lokal senkrecht auf die gekrümmte Oberfläche des Trägers 16 steht.

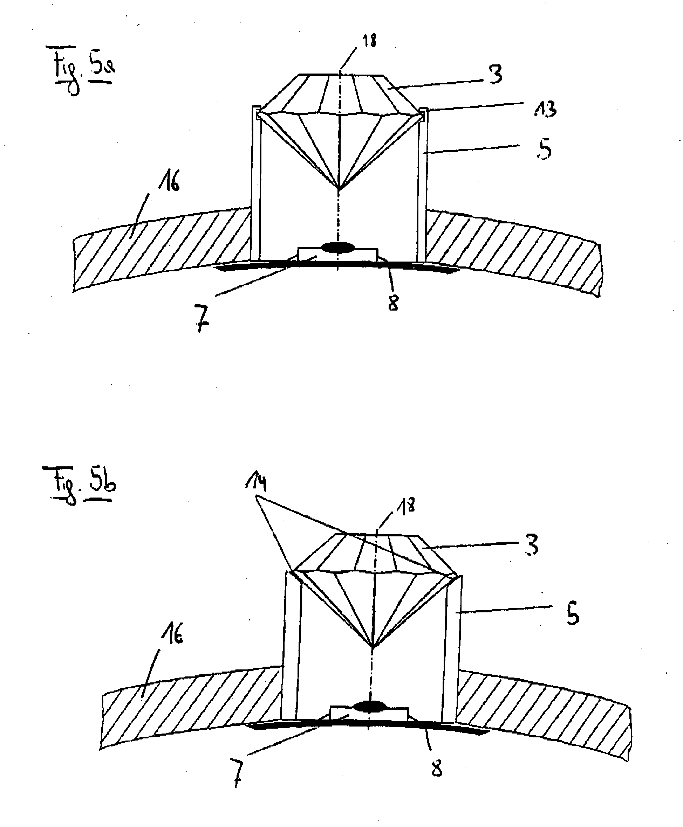

Fig. 5a zeigt, wie in einer vorteilhaften Ausführungsform der Erfindung ein in diesem Fall facettiert geschliffener Schmuckstein 3 von einer eigenen zylinderförmigen Fassung 5 gehalten wird. Im hier dargestellten Fall ist unter diesem Schmuckstein 3 eine Leuchtdiode 7 angeordnet, die mit der gekrümmten Leiterplatte 8 in Verbindung steht. Die zylinderförmige Fassung 5 steht dabei vom Träger 16 ab, wobei das abstehende Ende der Fassung 5 einen gebördelten Rand 13 aufweist, durch den der Schmuckstein 3 von der Fassung 5 gehalten wird. Die Längsachse 18 der zylinderförmigen Fassung 5 steht im Wesentlichen senkrecht auf die Oberfläche des Trägers 16.

Figur 5b zeigt eine weitere Ausführungsform der Erfindung. In diesem Fall ist der Schmuckstein 3 mittels einer Klebstoffschicht 14 an die Fassung 5 geklebt und wird dadurch von der Fassung 5 gehalten. Dabei werden herkömmliche, zur Verbindung zwischen Metall und Schmuckstein verwendete Klebstoffarten verwendet.

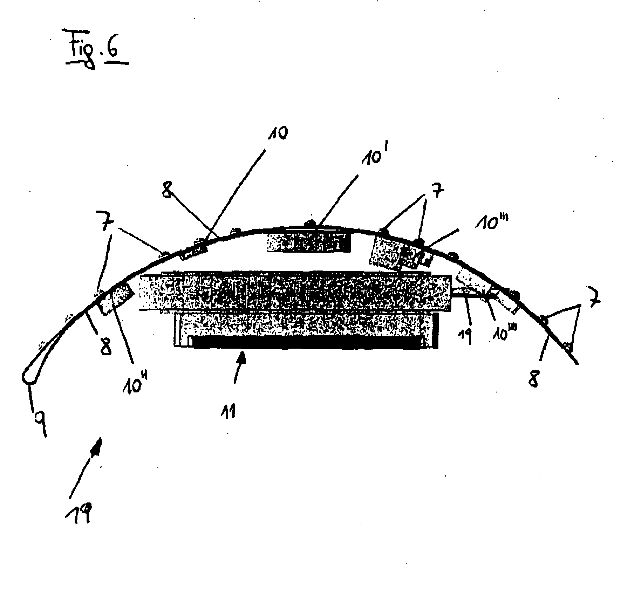

Fig. 6 zeigt eine schematische Darstellung der gesamten Steuereinrichtung 19 der Armbanduhr 1 und der zur Realisierung der Zeitanzeige dienenden Leuchtdioden 7. Die Steuereinrichtung 19 umfasst eine gekrümmte Leiterplatte 8, die einen gefalteten Bereich 9 aufweist und die zur elektrischen Verbindung der Leuchtdioden 7, die auf der gekrümmten Leiterplatte 8 befestigt sind, dient. Unterhalb der gekrümmten Leiterplatte 8, die zur Realisierung der Faltung 9 flexibel sein kann, sind verschiedene Steuereinrichtungen 10, 10', 10", 10"',10"" angeordnet, die mit einer weiteren Steuereinheit 11, die auch ein Element der Steuereinheit 19 darstellt, über das Verbindungselement 19 verbunden sind. Die Steuereinrichtungen 10, 10', 10", 10"',10"" sind ebenfalls direkt auf die Leiterplatte 8 aufgebracht.

Aufgrund dieser Flexibilität kann die Leiterplatte 8 in ebenem Zustand mit den Leuchtdioden 7 und den Steuereinrichtung 10, 10', 10", 10"',10"" bestückt werden, um erst in montiertem Zustand die gekrümmte und/oder gefaltete Form anzunehmen.

Mit den Steuereinrichtungen 10, 10', 10", 10"', 10"", sowie der Steuereinrichtung 11 wird die Zeitanzeige realisiert, indem jeweils einige der Leuchtdioden 7 selektiv angesteuert werden, um Licht auszustrahlen. In der Steuereinheit 11 sind neben der Stromversorgung auch die Mittel zur Taktgebung der Uhrzeit, also beispielsweise ein Quarzkristall, angeordnet. Außerdem können damit eine Datumsanzeige gesteuert werden, ebenso wie Farbe und Helligkeit des von den Leuchtdioden 7 abgestrahlten Lichts. Auch weitere an und für sich bekannte Merkmale, die bei Digitaluhren möglich sind, können implementiert sein.

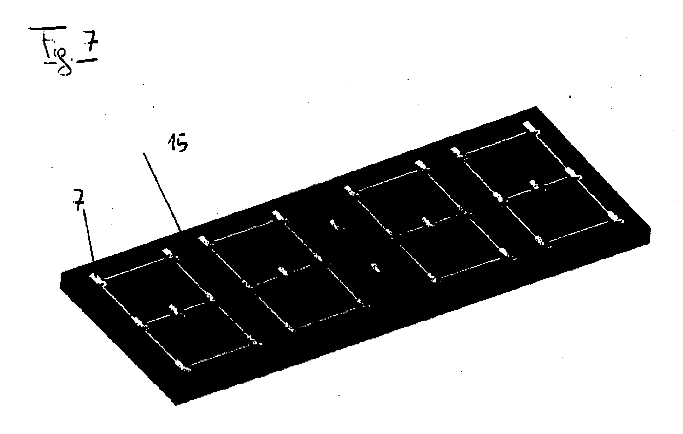

Fig. 7 zeigt das Prinzip der Zeitanzeige mittels Leuchtdioden 7. In dem hier dargestellten Beispiel sind auf einer Leiterplatte 15, die hier eben ausgebildet ist, mehrere Leuchtdioden 7 angeordnet. Die Gesamtzahl der angeordneten Leuchtdioden 7 dient zur Realisierung einer alphanumerischen Zeitanzeige, wobei jeweils einzelne der Leuchtdioden 7 Licht emittieren und dabei die jeweilige Uhrzeit darstellen.

Es versteht sich von selbst, dass die erfindungsgemäße Vorrichtung zur Zeitanzeige nicht auf die in den Figuren oder in der Beschreibung dargestellten Ausführungsbeispiele beschränkt ist noch durch diese eingeschränkt werden soll.

Dabei kann die Erfindung sowohl nur eine Art von Schmucksteinen hinsichtlich Form und/oder Material als auch eine Mehrzahl verschiedenartiger Schmucksteine aufweisen, als homogen oder heterogen aufgebaut sein. Auch müssen nicht alle Schmucksteine gleich in den Fassungen angeordnet sein, obgleich dies bevorzugt ist.

## Patentansprüche

1. Vorrichtung zur Zeitanzeige, insbesondere eine Armbanduhr, umfassend eine Mehrzahl von Schmucksteinen und eine Mehrzahl von Beleuchtungselementen, über die die Schmucksteine zur Realisierung einer Zeitanzeige selektiv beleuchtbar und/oder durchleuchtbar sind, sowie eine Steuerungseinrichtung zur Ansteuerung der Beleuchtungselemente, wobei die Steuerungseinrichtung eine Leiterplatte umfasst, **dadurch gekennzeichnet, dass** die Leiterplatte (8) im montierten Zustand gekrümmt ist.

2. Vorrichtung nach Anspruch 1, **dadurch gekennzeichnet, dass** die Leiterplatte (8) flexibel ist.

3. Vorrichtung nach Anspruch 1oder 2, **dadurch gekennzeichnet, dass** die Leiterplatte (8) in einem starren Gehäuse (2) angeordnet ist.

4. Vorrichtung nach einem der Ansprüche 1 bis 3, **dadurch gekennzeichnet, dass** die Leiterplatte (8) in einem Bereich (9) gefaltet ist.

5. Vorrichtung nach einem der Ansprüche 1 bis 4, **dadurch gekennzeichnet, dass** die Leiterplatte (8) eine Dicke zwischen 0,075 mm und 0,2 mm, vorzugsweise etwa 0,125 aufweist.

6. Vorrichtung nach einem der Ansprüche 1 bis 5, **dadurch gekennzeichnet, dass** die Beleuchtungselemente an oder auf der Leiterplatte (8) befestigt, vorzugsweise aufgelötet, sind.

7. Vorrichtung nach einem der Ansprüche 1 bis 6, **dadurch gekennzeichnet, dass** das Basismaterial der Leiterplatte (8) Polyimid umfasst.

8. Vorrichtung nach einem der Ansprüche 1 bis 7, **dadurch gekennzeichnet, dass** die Beleuchtungselemente als Leuchtdioden (7) ausgebildet sind oder Leuchtdioden (7) umfassen.

9. Vorrichtung nach einem der Ansprüche 1 bis 8, **dadurch gekennzeichnet, dass** die Schmucksteine (3) natürliche oder künstliche, vorzugsweise geschliffene, Glassteine aufweisen.

10. Vorrichtung nach einem der Ansprüche 1 bis 9, **dadurch gekennzeichnet, dass** die Spitzen und/oder Tafeln der Schmucksteine (8) eine einhüllende Fläche definieren, welche eine, vorzugsweise konvexe, Krümmung aufweist.

11. Vorrichtung nach einem der Ansprüche 1 bis 10, **dadurch gekennzeichnet, dass** die Schmucksteine (3) zumindest abschnittsweise in Reihen und Spalten angeordnet sind.

12. Verfahren zur Herstellung einer Vorrichtung nach einem der Ansprüche 1 bis 11, **dadurch gekennzeichnet, dass** die Leiterplatte (8) flexibel ist und in einem ebenen Zustand mit den Beleuchtungselementen und/oder Steuereinrichtungen (10, 10', 10". 10"', 10"") bestückt wird und erst zur oder während der Montage in der Vorrichtung gekrümmt und/oder gefaltet wird.
